(19) Europäisches Patentamt
European Patent Office
Office européen des brevets

(11) EP 4 764 877 A1

(12) **EUROPEAN PATENT APPLICATION**

(43) Date of publication:
24.06.2026 Bulletin 2026/26

(51) International Patent Classification (IPC):
*G06F 13/40* (2006.01)

(21) Application number: 25216346.4

(52) Cooperative Patent Classification (CPC):
G06F 13/4045

(22) Date of filing: 17.11.2025

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 20.12.2024 US 202418990260

(71) Applicant: NXP USA, Inc.
Austin, TX 78735 (US)

(72) Inventors:
• Jaramillo, Kenneth
5656AG Eindhoven (NL)
• Vertenten, Bart
5656AG Eindhoven (NL)
• Papadasu, Sivakumar Reddy
5656 AG Eindhoven (NL)

(74) Representative: Schmütz, Christian Klaus
Johannes
NXP Semiconductors Germany GmbH
Intellectual Property Group
Beiersdorfstr. 12
22529 Hamburg (DE)

(54) **EUSB DEVICE REPEATER FAST END OF USB2 BUS RESET DETECTION**

(57) A USB-capable device includes an eUSB device repeater includes D+ and D- lines for communicating via a USB bus, and eD+ and eD- lines for communicating via an eUSB bus. The repeater includes a squelch detector for detecting a differential voltage between the D+ and D- lines and comparing it to a squelch threshold voltage based on a selectively variable squelch threshold voltage level at the squelch detector. During USB bus reset the squelch detector compares the differential voltage to a chirp-specific squelch threshold voltage level and the squelch signal indicates no K chirp or J chirp activity on the USB bus. The repeater thereby avoids false detections of invalid chirps and more reliably detects end of USB bus resets. A USB2 bus reset sequence windowing scheme is also provided.

FIG. 4

## Description

## TECHNICAL FIELD

This invention relates generally to electronic devices, and more specifically to an electronic device including an eUSB device repeater.

## RELATED ART

The Universal Serial Bus (USB) reset protocol is a critical mechanism in the USB standard that enables a USB host to reset a connected device, ensuring it initializes correctly or returns to a known state after an error or abnormal condition. The protocol serves two primary purposes: initialization of a new device when connected to the host and recovery of a device that is unresponsive or in an erroneous state.

An Embedded Universal Serial Bus (eUSB) repeater is a specialized hardware component designed to enhance signal integrity and extend the range of USB data transmission within electronic systems. Unlike USB repeaters, eUSB repeaters are typically embedded into devices, circuit boards, or within system enclosures to maintain robust communication between USB host controllers and peripheral devices. These repeaters function by amplifying, reshaping, and retransmitting USB signals to counteract signal degradation caused by factors such as long cable lengths, electromagnetic interference, or high-speed data rates. Additionally, eUSB repeaters often incorporate advanced features such as protocol handling, data error correction, and support for multiple USB standards (e.g., USB 2.0 or USB 3.x).

The eUSB protocol is a streamlined, compact version of the USB protocol, specifically designed for use in embedded systems where space, power consumption, and cost are limited. It supports many of the same features as traditional USB, including data transfer, device enumeration, and power management, but operates in a more power-efficient and compact manner.

## BRIEF DESCRIPTION OF THE DRAWINGS

The accompanying figures, in which like reference numerals refer to identical or functionally similar elements throughout the separate views, and which together with the detailed description below are incorporated in and form part of the specification, serve to illustrate various examples and to explain various principles and advantages all in accordance with the present disclosure, in which:

FIG. 1 is a block diagram illustrating an example of a host including a USB2 host repeater and a peripheral device including a USB2 device repeater, wherein each repeater can include a USB2 variable squelch level circuit and the repeaters are interconnected via a USB cable, according to various embodiments of the present invention;

FIG. 2 is a table showing USB2 high-speed squelch bus state signaling, according to a current USB2 standard;

FIG. 3 is a table showing USB2 high-speed receiver DC specifications regarding squelch detection threshold, according to a current USB2 standard;

FIG. 4 is a circuit block diagram illustrating an example of a variable squelch level circuit suitable for use in an eUSB2 peripheral device repeater, such as shown in FIG. 1, according to various embodiments of the present invention;

FIGs. 5A and 5B are a signal timing diagram illustrating an example of a USB2 bus reset sequence received by a receiver in an eUSB2 peripheral device repeater, such as shown in FIG. 1. The bus signaling illustrates the repeater, including a squelch detector circuit and a variable squelch level circuit as shown in FIG. 4, receiving noisy USB host chirp signals from a USB bus, according to various embodiments of the present invention.

FIGs. 6A and 6B are a signal timing diagram illustrating an example of a USB2 bus reset sequence similar to the example shown in FIGs. 5A and 5B. However, the bus signaling illustrates the eUSB2 peripheral device repeater receiving clean host chirp signals from the USB bus, according to various embodiments of the present invention.

FIGs. 7A and 7B are a flow diagram illustrating an example operational sequence for an eUSB2 peripheral device repeater configured with a variable squelch level circuit, as shown in FIG. 4, according to various embodiments of the present invention.

## DETAILED DESCRIPTION

As required, detailed embodiments are disclosed herein; however, it is to be understood that they are merely examples and that the devices, systems, and methods described herein can be embodied in various forms. Therefore, specific structural and functional details disclosed herein are not to be interpreted as limiting but merely as a basis for the claims and as a representative basis for teaching one of ordinary skill in the art to variously employ the disclosed subject matter in virtually any proprietary detailed structure and function. Further, the terms and phrases used herein are not intended to be limiting but rather to provide an understandable description. Additionally, unless otherwise specifically expressed or clearly understood from the context of use, a term used herein describes the singular and/or the plural of that term.

Non-Limiting Definitions

The terms "eUSB" and "eUSB2", and "USB" and "USB2", may be used interchangeably in this disclosure. Unless the context of using the term is clearly understood to mean a specific USB and eUSB standard (e.g., "embedded Universal Serial Bus 2.0 standard"), the term should be understood to mean USB and/or eUSB supporting multiple USB standards.

Introduction

The Universal Serial Bus (USB) reset protocol is a critical mechanism in the USB standard for a USB host to reset a connected device, ensuring it initializes correctly or returns to a known state after an error or abnormal condition. The reset process begins when the host sends a signal by driving the data lines (D+ and D-) to a specific state for a defined period. Both lines are held low for at least 10 ms for high-speed devices, while for full-speed or low-speed devices, D+ line (or D-) is driven low for the same duration. The USB2 device cannot communicate during this time, while internal initialization tasks include resetting its USB address to 0 (unaddressed state). Once the reset signaling ends, the host ceases to drive the lines low, and the device indicates its presence by applying the appropriate termination to the D+ and D- lines, depending on its speed. If the reset ends up with high-speed host and device, the device applies its high-speed terminations. If the device is a full speed device it keeps its pullup on D+ the entire reset. If a device is a low-speed device, it keeps its pullup on D- the entire reset. Following the reset, the host begins the enumeration process, requesting device descriptors to identify the device type, vendor ID, product ID, and supported configurations. The USB reset protocol is essential for error recovery, reinitialization, and ensuring that devices are ready to communicate after power cycling or hot-plugging, contributing to USB technology's robustness and plug-and-play capability.

An eUSB repeater (also referred to as eUSB device repeater) is a specialized hardware component designed to enhance signal integrity and extend the range of USB data transmission within electronic systems and devices. Unlike USB repeaters, eUSB repeaters are typically embedded into devices, circuit boards, or system enclosures to maintain high signal fidelity and robust communication between USB host controllers and peripheral devices. These repeaters function by amplifying, reshaping, and retransmitting USB signals to counteract signal degradation caused by long cable lengths, electromagnetic interference, or high-speed data rates. They play a critical role in applications requiring reliable USB connectivity over extended distances or in challenging environments, such as industrial automation, automotive systems, embedded computing platforms, mobile phones, and wireless communication devices.

The eUSB repeater typically operates more power-efficiently and uses lower voltage eUSB bus signals than a USB repeater.

Normally, USB2 bus reset signaling works well and is straightforward to detect the various stages of the bus reset sequence (e.g., initial SE0 to indicate bus reset, one device chirp, several host chirps, and the end of reset, which varies based on the speed of the USB2 host and Device. The USB2 standard specification defines chirps as how the device and host communicate with each other during USB2 bus resets to convey speed information. A device first generates a single chirp K during the USB2 bus reset sequence if it is a high-speed device. A host then generates alternating chirp K and chirp J sets to convey to the device that it is a high-speed host. Chirps are signaled using the host and device's high-speed transmitters. This protocol is described in the USB2 standard specification.

Various things may go wrong during the USB2 bus resets, which can make the reset operation fail or fail to resolve correctly. The speed negotiation may fail. Even the detection of the end of the bus reset may fail. Because of these things, the USB2 host and device may finish in completely different states. For example, the host may end up in its high-speed L0 state, ready to send high-speed packets, and the device may end up stuck looking for the end of the reset. Or the device may end up in its full-speed L0 state, ready for full-speed packets.

When eUSB repeaters (particularly eUSB device repeaters) are used in a system, the detection of an end of a USB2 bus reset, particularly under error conditions, becomes complex as the eUSB repeaters cannot use the same end of reset detection as called out in the USB2 specification. eUSB device repeaters do not know the limitations of the eUSB devices to which they are connected, and so they must behave in a manner that makes it easiest for their eUSB devices to detect the entire USB2 bus reset sequence. The eUSB specification describes the overall handling of the USB2 bus resets, but it does not specify how the eUSB device repeater should detect the end of a USB2 bus reset.

Examples of a USB2 Host interconnected with a USB2 Device

According to various embodiments of the invention, an eUSB device repeater can reliably detect an end of a USB bus reset while contemporaneously avoiding detection of invalid J and K chirps on the USB bus. The repeater has an eUSB transceiver including: D+ and D- lines for communicating via a USB bus with a USB host, and has eD+ and eD- lines for communicating via an eUSB bus with eUSB device. A squelch detector is electrically coupled to the D+ and D- lines for detecting a differential voltage therebetween and comparing it to a selectively variable squelch threshold voltage level at an input of the squelch detector circuit. The squelch detector provides a squelch signal at its output based on the comparison.

A selector circuit has an output connected to the input of the squelch detector thereby providing a selectively variable squelch threshold voltage level at the input of the squelch detector. The selector circuit selects and provides at its output a squelch threshold voltage level based on a selected one of a plurality of squelch threshold voltage levels. The selected squelch threshold voltage level, which is the selectively variable squelch threshold voltage level at the input of the squelch detector, is used by the squelch detector for the comparison.

According to one example embodiment, the repeater includes a squelch threshold voltage generating circuit that outputs the plurality of squelch threshold voltage levels at a respective plurality of outputs of the squelch threshold voltage generating circuit which are connected to a respective plurality of squelch threshold voltage level inputs of the selector circuit.

According to various embodiments, the selector circuit provides at its output a normal squelch threshold voltage level that complies with the USB2 standard, or a chirp-specific squelch threshold voltage level that is a higher DC voltage than the normal squelch threshold voltage level, based on the selector circuit selecting one of the plurality of squelch threshold voltage levels generated by the squelch threshold voltage generating circuit at one of the plurality of squelch threshold voltage level inputs of the selector circuit.

A state machine of the repeater outputs a selection signal at an input of the selector circuit to select one of the squelch threshold voltage level inputs of the selector circuit and provides a squelch threshold voltage, which is the selectively variable threshold voltage level, at an output of the selector circuit based on the selected one of the squelch threshold voltage level inputs.

According to various embodiments, the squelch signal, from the squelch detector circuit, indicates to the state machine whether a valid J-chirp or a valid K-chirp is present on the USB bus. The eUSB device repeater includes two single-ended USB signal receiver circuits electrically coupled to the D+ and D- lines of the USB bus (one receiver coupled to D+ and the other coupled to D-) for detecting a valid SE0 state present on the USB bus, the eUSB device repeater determining a start of a USB bus reset based on the eUSB device repeater detecting a valid SE0 state on the USB bus. During a USB bus reset the state machine provides a selection signal to the input of the selector circuit thereby providing to the input of the squelch detector circuit a chirp-specific squelch threshold voltage level that is a higher DC voltage than a normal squelch threshold voltage level that complies with the USB2 standard, and thereby the squelch signal from the output of the squelch detector circuit indicates to the state machine no valid J-chirp or valid K-chirp is present on the USB bus during the USB bus reset, while contemporaneously the eUSB device repeater detects a valid SE0 state on the USB bus.

The eUSB device repeater, according to various embodiments, is configured to support USB2 communications over a USB2 bus and eUSB2 communications over an eUSB2 bus, according to the USB 2.0 and eUSB 2.0 standards. In some of the embodiments, the eUSB device repeater is configured to support USB communications over a USB bus according to multiple USB standards, including any one or more of USB 2.0 or USB 3.x.

The eUSB device repeater, in some example embodiments, can be configured to selectively operate as one of a USB device role or a USB host role.

The USB-capable device can be at least one of the following: a portable device, a mobile phone, a PC, a USB hub, an external storage device, a modem, a mouse, a keyboard, or any combination thereof. A USB-capable device can be in other products such as the entertainment unit of a car (Apple CarPlay, Android auto) as well.

Features and advantages of the above-described various embodiments will become readily apparent from the following description and accompanying drawings. Certain preferred embodiments of the invention and their benefits will also become more apparent to a person of ordinary skill in the art through the description and selected examples given herein below, and through the appended claims.

All references, publications, patents, and patent applications, cited herein and/or cited in any accompanying Information Disclosure Statement (IDS), are hereby incorporated herein by reference in their entirety for all purposes.

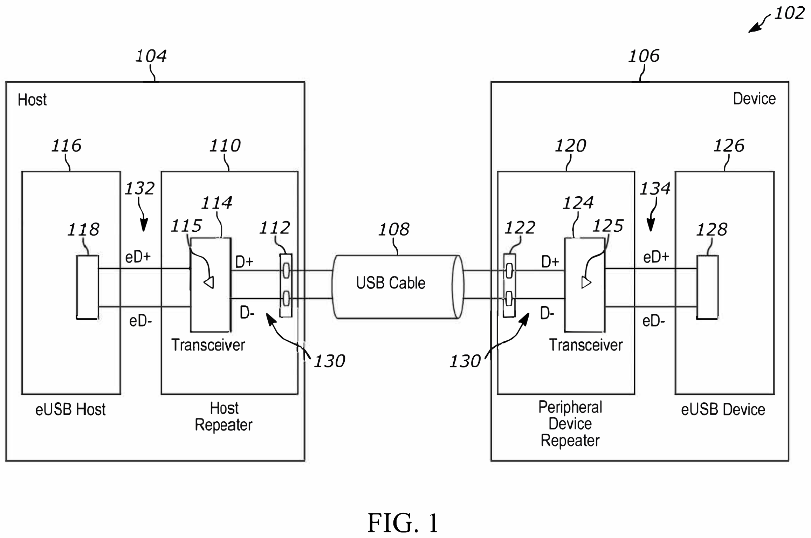

FIG. 1 illustrates an example of a USB-based communication system 102 comprising a host 104 including a USB2 host repeater 110 interconnected via a USB cable 108 with a peripheral device 106 including a USB2 device repeater 120.

Host 104, in this example, includes the USB2 host repeater 110 which includes a USB connector 112 that is connected to the USB cable 108 which also has a connector on either end (not shown). The USB connector 112 connects the D+ line and the D- line to a transceiver 114. The transceiver 114 is connected via an eUSB bus 132 with a connector 118 of an eUSB host 116. The eUSB bus 132 interconnects an eD+ line and an eD- line between the transceiver 114 and the eUSB host 116. The transceiver 114 converts the USB signals of the USB D+ line and the USB D- line on the USB bus 130 to corresponding eUSB D+ and eUSB D- signals on the eUSB bus 132, and vice versa. The transceiver 114 includes a novel squelch detector circuit 115, which will be discussed in more detail below.

The device 106 includes a peripheral device repeater 120, which includes connector 122 and transceiver 124. The transceiver 124 is interconnected with a connector 128 of an eUSB device 126 via an eUSB bus 134. The eUSB bus 134 includes an eD+ line and an eD- line. The transceiver 124 converts the USB signals of the USB D+ line and the USB D- line on the USB bus 130 to corresponding eUSB D+ and eUSB D- signals on the eUSB bus 134, and vice versa. The transceiver 124 includes a novel squelch detector circuit 125, which will be discussed in more detail below.

It should be apparent that the host 104 and the device 106 can represent many types of USB-capable systems and devices that can be interconnected via a USB cable 108. For example, and not for limitation, the host 104 can be a mobile phone, a PC, or a USB hub, and the device can be a peripheral device for use with the mobile phone or the PC, or connected to the USB hub. For example, it can be an external storage device, a modem, a mouse, a keyboard, or any other USB-capable peripheral device. In specific configurations of system 102, device 106 could be another mobile phone or PC operating in a peripheral device role, or a USB hub. It should be understood that a mobile phone, a PC, or another USB-capable device or system, typically includes a processor and memory that can include computer instructions for execution by the processor. An eUSB repeater can be communicatively coupled with the processor and the memory of the USB-capable device operating in either the device role or the host role. In the host role, the eUSB repeater would operate as a USB host repeater. In the device role, the eUSB repeater would operate as a USB device repeater.

According to another example, two mobile phones can connect to each other. One will be host and the other will be device. But depending on what the user wants to perform, the USB roles can be swapped such that the mobile phone that was a USB host will switch to a USB device role, and the mobile phone which was a USB device will switch to a USB host role. In this case, both sides would disconnect from each other (not physically but logically), internally swap their roles, then reconnect to each other with the new roles.

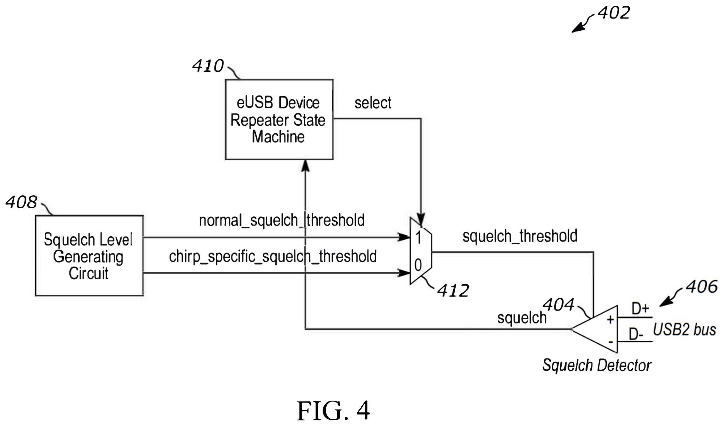

FIG. 4 illustrates an example USB transceiver 402, 114, 124, including a novel squelch detector circuit 404 and a variable squelch level selector circuit, which includes a squelch threshold voltage generating circuit 408 and an eUSB device repeater state machine circuit 410, electrically coupled to a squelch level selector circuit 412. The generating circuit 408 can be designed and configured to generate two or more levels of squelch threshold, a normal squelch threshold and a chirp-specific squelch threshold voltage level that is a higher DC voltage than the normal squelch threshold voltage level that complies with the USB2 standard.

It should be noted that while a state machine circuit is used to illustrate the present example, it is only used as an example and should not be considered a limiting feature of various embodiments. Other equivalent systems and devices are anticipated to be used in various embodiments, such as a processor, information processor, processing system, computer, computer instructions, controller, and the like.

In some embodiments, the threshold voltage generating circuit 408 could be designed and configured to generate more than two levels of the squelch threshold voltage levels. The eUSB device repeater state machine 410 could select between the normal squelch threshold voltage level and any alternative squelch threshold voltage level selected from a plurality of alternative levels that can be used in various embodiments of the present invention.

For example, the squelch threshold voltage generating circuit 408 can include at least one resistor ladder with a reference voltage and a variable resistance (not shown) configurable to a desired output DC voltage from the resistor ladder, one output for the normal squelch threshold, and separately a second output for the chirp-specific squelch threshold. As mentioned above, the eUSB device repeater state machine 410, according to various embodiments, could select between the normal squelch threshold voltage level and any alternative squelch threshold voltage level selected from a plurality of alternative levels.

In the current example shown in FIG. 4, the state machine 410 can set a select output line to a one or a zero value. That is, for example, the state machine circuit 410 would provide a selection signal to an input of the selector circuit 412. This select output signal controls the selector circuit 412 to quickly output a squelch threshold level that is electrically coupled to an input of the squelch detector circuit 404. The squelch detector circuit 404 compares a differential voltage on the USB2 bus to the squelch threshold level at the input of the squelch detector circuit 404. In this way, the state machine 410 can select a squelch threshold level for use by the squelch detector circuit 404, which outputs a squelch signal, either a one or a zero, and couples the squelch signal to the state machine 410.

The state machine 410 operating in the transceiver 124 of the peripheral device repeater 120 can selectively raise the squelch threshold voltage level used by the squelch detector circuit 404, above (higher than) the normal squelch voltage level specified by the USB2 standard. The squelch threshold voltage level can be raised, for example, during a time period when the peripheral device repeater 120 is expecting to receive chirp signals from the host. After that time period, the state machine 410 can selectively return the squelch threshold voltage to the normal squelch voltage level.

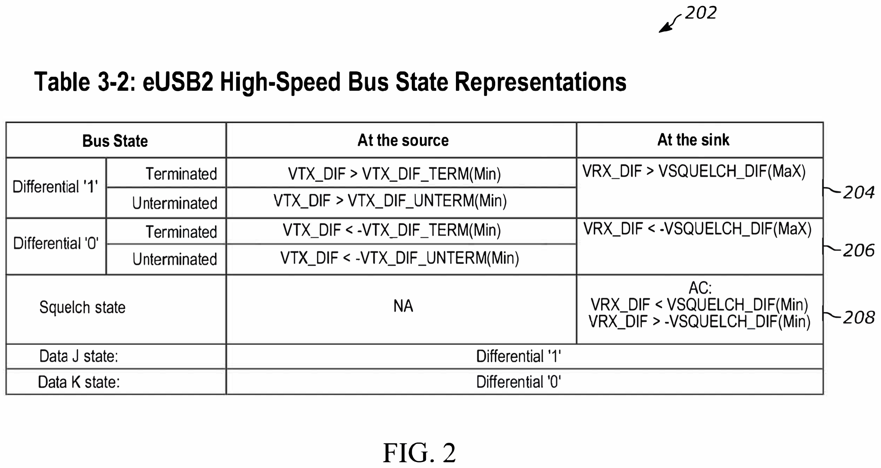

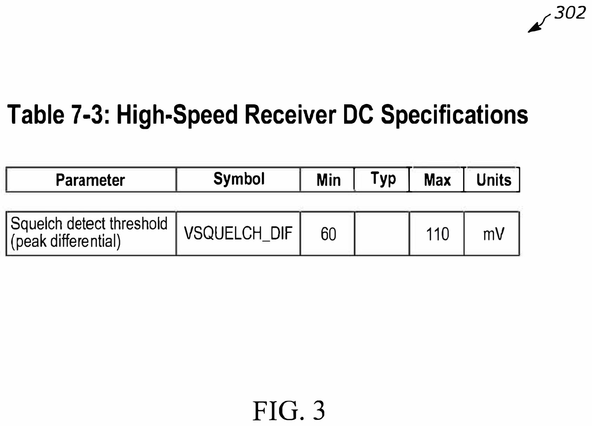

At an eUSB transceiver 124 of a peripheral device repeater 120, the voltages of the valid differential "1" bus state and valid differential "0" bus state are defined by the USB2 standard and detected valid relative to a squelch detection threshold level. See FIG. 2 and FIG. 3, table 7-3 202 and table 7-7 302 from the USB2 standard specifying the minimum and maximum squelch differential threshold voltage levels. The transceiver 124 of the peripheral device repeater 120 uses the squelch detector circuit 404 to determine when the differential voltage level between the USB bus D+ line and the USB bus D- line is valid or invalid. The receiver of a peripheral device repeater includes squelch detector circuits that indicate when the differential voltage level between the USB bus D+ line and the USB bus D- line is less than 100mV DC threshold level and when it is greater than 150mv DC threshold level. The receiver must indicate squelch when the magnitude of the differential voltage is less than or equal to 100mV. The receiver must not indicate squelch if the magnitude of the differential voltage is greater than or equal to 150mV. D+ being high and D- being low is a differential '1' (J) and D- being high and D+ being low is a differential '0' (K).

During a USB2 bus reset sequence, according to various embodiments, the eUSB device repeater 120 raises its high-speed squelch threshold at the squelch detector 404, 125 when host J-K chirps are expected. This allows the eUSB device repeater 120 to ignore the differential voltage on USB2 during SE0, such as due to the eUSB device repeater's pullup resistor on D+ in combination with the USB2 host/hub's high-speed termination. Because of this, the squelch detector 404 can be relied upon to accurately reflect the presence of a high-speed signal (chirp) or not (SE0) on the USB bus 406. Accordingly, this novel feature embedded in an eUSB device repeater 110, 120 whether found in a peripheral device 106 or in a host 104 that can change USB device roles of operation and at times operate like a peripheral device, increases the commercial viability and desirability of USB-capable devices and hosts.

Overcoming Problems With Detection of the End of USB2 Bus Reset

Various embodiments of the invention provide a method for an eUSB device repeater to detect the end of a USB2 bus reset while 1) detecting the end of the reset issued by a full-speed host (device may or may not be high-speed capable), pulsing eD+ to the eUSB device to indicate the end of reset, and transitioning to its FS L0 state all within 600ns, and 2) detecting the end of the reset even with invalid host chirps and potential differential voltage on USB2 bus during the SE0 phases.

Given that the eUSB device repeaters must support the non-USB2 compliant full-speed USB2 hubs, which issue start of frame packets within 600ns of the end of reset, detecting the end of USB2 bus resets can be very challenging considering all of the various things that can go wrong during the reset. Various embodiments of the invention provide a method for an eUSB device repeater to detect the end of USB2 bus resets, which meets the 600ns requirement of the non-USB2 compliant USB2 hubs and is also capable of detecting the end of USB2 bus resets under various error conditions.

Examples of things that may go wrong during a USB2 bus reset sequence include the following.

1) Rather than the USB2 Bus being at an SE0 state during the USB2 bus reset, it may look like a high-speed J due to the pullup resistor on the device's USB2 D+ line. The USB2 standard specification defines the SE0 state as one in which both lines on the USB2 bus (D+ and D-) are at a low voltage. This conveys many things on the bus (bus reset, end of packet, etc.). The USB2 standard specification defines J and K states as a way of defining the USB2 bus state. During both full-speed and high-speed modes, a J state is one in which the D+ line is at a higher voltage than the D- line. A K state is one in which the D- line is at a higher voltage than the D+ line.

FIG. 2 shows a portion of Table 7-3 202 from the USB standard specification. The high-speed squelch state has defined signaling level requirements 204 at the receiver (i.e., a receiver portion of the transceiver 124). The receiver must indicate squelch when the magnitude of the differential voltage is less than or equal to 100mV. The receiver must not indicate squelch if the magnitude of the differential voltage is greater than or equal to 150mV.

Additionally, FIG. 3, shows a portion of Table 7-7 302 from the USB standard specification specifying the DC electrical characteristics for high-speed differential signal amplitude for squelch detection threshold level. The receiver of a peripheral device repeater includes squelch detector circuits that indicate when the differential voltage level between the USB bus D+ line and the USB bus D- line is less than 100mV DC threshold level and when it is greater than 150mv DC threshold level. The receiver must indicate squelch when the magnitude of the differential voltage is less than or equal to 100mV. The receiver must not indicate squelch if the magnitude of the differential voltage is greater than or equal to 150mV. During a squelch state, the receiver of a peripheral device repeater can disregard these differential voltage signals as invalid data.

The receiver typically sets its squelch threshold between the limits of high-speed squelch detection threshold voltage VHSSQ (100-150mV). If the differential voltage is in this range (positive or negative), then it's a valid bit. D+ being high and D- being low is a differential '1' (J) and D- being high and D+ being low is a differential '0' (K).

Continuing with the discussion of things that may go wrong during a USB2 bus reset sequence, since an SE0 state during a USB2 bus reset may look to the eUSB2 device repeater like a high-speed J state, this can confuse the eUSB2 device repeater into thinking it sees a high-speed J chirp condition rather than an SE0. This depends on the value of the eUSB device repeater's pullup resistor, which can result in the voltage at its D+ and/or D- being pulled up to the voltage threshold of the eUSB device repeater's high-speed receiver and/or its squelch detector.

2) The USB2 host's chirp voltage may be larger than allowed in the USB2 specification such that when doubled (due to a mismatch between USB2 host high-speed terminations and the USB2 device's lack of high-speed terminations), then this voltage may be above the normal USB2 Full Speed J voltage level. If the J chirp voltage is high enough to look like a full-speed J voltage, then this can look like the end of a reset for a full-speed host rather than just the normal host K-J chirps sequence. This may be due to a normally compliant USB2 host configured by its system to generate a chirp voltage that is too high.

3) The host chirps may be noisy, including periods of SE0. This may make validating the host chirps difficult for the eUSB device repeater. The SE0 during the chirps may confuse the eUSB device repeater into thinking it sees the normal period of SE0 at the end of reset after all host chirps are done.

4) The eUSB device may not be able to detect valid host chirps and may not pulse eD+ to the eUSB device repeater to indicate valid host chirps detected. This pulse on eD+ is the request from the eUSB device to the eUSB device repeater to apply its high-speed terminations for the remainder of the bus reset. In the successful end of reset situations with a high-speed host and high-speed device, this pulsing of eD+ helps the eUSB device repeater detect the end of reset because it tells the repeater that the device has detected valid host chirps and will then switch to its high-speed L0 state.

5) There is a very popular non-USB2 compliant USB2 full-speed hub that ends a USB2 bus reset and then immediately (within 600ns) starts sending the start of frame packet to start the USB2 full-speed operation. The hub does not support packet errors during this time. The full-speed hub is not supposed to send the start of the frame until much later (on the order of 1ms) after the end of the USB2 bus reset (the USB2 bus going from SE0 to J state). For an eUSB device repeater to support this makes detecting the end of USB2 bus resets difficult, given that things can go wrong during the USB2 bus reset sequence.

Note that after the end of reset is detected, the eUSB device repeater must generate a strobe (500ns - 1.5μs) on eD+ to indicate the end of reset to the eUSB device. If 500ns is chosen as the minimum with a design clock variation of +/- 5%, then the strobe alone could take ~550ns, leaving only ~50ns to detect the end of reset and act upon it.

An eUSB device repeater should be able to successfully detect the end of the USB2 bus reset sequence even under these error scenarios. This is important because if the eUSB repeater cannot detect the end of the reset, then it may lead to more serious system issues that are difficult for the USB2 host to resolve.

The eUSB specification does not specify how the eUSB repeater should perform this detection. Therefore, the inventors have invented a robust system hardware and method for detecting the USB2 bus reset. Various embodiments of the present invention can avoid the above-mentioned problems and failure modes. Example embodiments will be more fully discussed below. It is anticipated that various embodiments of the invention can be used in eUSB repeaters that support multiple USB standards (e.g., USB 2.0 or USB 3.x), and similarly support multiple eUSB standards.

Overview of an Example of a USB2 Bus Reset Sequence

The basics of a USB2 bus reset include the following. Note that this overview skips many details and assumes that the system comprises only a USB2 host and USB2 device with no repeaters in the path.

1) The USB2 host/hub drives the USB2 bus to SE0 state for 10ms minimum.

2) The USB2 device detects the reset and issues its device chirp K if it is a high-speed capable device. The USB2 device uses high-speed USB2 drivers to drive current into the D-line to signal its chirp K.

3) The host detects the device's chirp. If the host is capable of high-speed USB communication, it will drive a series of K and J chirps back to the device to indicate its speed. The host drives a constant repetition of K chirp - J chirp - K chirp - J chirp - ... until near the end of the bus reset sequence, when the host will drive the USB2 bus to SE0 until the end of reset. After this, the host eventually starts the USB2 high-speed microframe by sending a micro start of the frame packet. The host drives its chirps using its high-speed USB2 drivers. Ideally, each host chirp is 40μs-60μs long and has no gap between them. Typically, there shouldn't be any signaling on the USB bus except K and J chirp signaling.

4) The device detects and validates the host chirps and enters HS L0 state as soon as it has detected at least three (3) valid K-J chirp pairs. If it does not detect three valid K-J chirp pairs within a timeout period (1-2.5ms), the device aborts the reset and enters the FS L0 state. Even though the host's K-J chirps during the USB2 bus reset sequence only have clean signaling, the USB2 specification does recommend that if a device sees any gap (not a K chirp or a J chirp) in the chirp signals as short as sixteen (16) high-speed bit times, it should restart its chirp duration timers.

5) The host should guarantee at least 40us of SE0 following its chirps before transitioning to its HS L0 state and starting the frame. Note that the host has no feedback to know if the device successfully detected its chirps or not. The host can end up in an HS L0 state, while the device can end up in an FS L0 state.

6) The host must generate chirps with the following differential voltage states (according to the USB2 standard specification). These voltages include the possibility that one side may have its HS terminations enabled while the other does not.

$$J \text{ chirp voltage} = 700\text{mv} - 1100\text{mv}$$

$$K \text{ chirp voltage} = (-900\text{mV}) - (-500\text{mV})$$

Note that some hosts may issue chirps with larger voltages that, when doubled during the HS terminations being enabled at the host side, the initial chirps may look to the eUSB device repeater like an FS J (indicating end of reset for full speed host).

7) SE0 state is a USB single-ended voltage on D+ and D- below 0.8V (pg. 178 of USB2 specification, VIL). The eUSB device repeater would include a single-ended USB signal receiver circuit that can couple an information signal to a USB state machine 410 to determine the presence of a valid SE0 state on the USB bus.

8) Tools a USB2 device may use to detect the end of reset are its single-ended receivers (SE0, FS J), HS squelch, and HS Rx data. A true FS J would indicate the end of a reset with an FS host or device. A prolonged SE0, after the host chirps start, would indicate the end of reset. An SE0 state detection by the eUSB device repeater is usually based on the single-ended receivers indicating SE0 and the squelch detector indicating no high-speed activity. This is made challenging due to the following:

During the host J-K chirp sequence, it could look to the eUSB device repeater as if SE0 is present the entire time (HS differential voltage < SE0 level).

It can also appear as if squelch is always low (active data), even at the end when SE0 is driven to finish the USB2 bus reset. This could happen if the host has its HS termination enabled, but the repeater still has its FS terminations enabled. If the resulting differential voltage is high enough, it will look like active data to the eUSB device repeater's squelch detector. But if it is right on the edge of the squelch threshold, then the squelch detector output could go up and down due to noise taking the signal up and down.

Advantages of Various Embodiments of the Invention

- Improved system function due to the use of the various embodiments of the invention.

- Reliably detects the end of USB2 bus reset given all combinations of host/device (full speed/full speed, full speed/low speed, full speed/high speed, high speed/full speed, high speed/low speed, high speed/high speed).

- Very quickly detects end of USB2 bus reset when USB2 host/hub is full speed and the eUSB device is low speed, full speed, or high speed. This is to support popular non-compliant USB2 hubs which require the device to detect end of reset and be ready for FS packets within 600ns of end of bus reset.

- Detects end of USB2 bus reset in the presence of invalid host chirps such that the eUSB device cannot detect valid host chirp sequence. These host chirps may contain SE0 conditions within or between chirps.

- Detects end of USB2 bus reset even when resulting differential voltage on USB2 bus is above its high-speed squelch detector threshold due to the combination of the host/hub's high-speed termination and the eUSB device repeater's full-speed termination.

- Detects end of USB2 bus reset even if USB2 host/hub generates J chirp voltage which is high enough, given reflections, to look like a full speed J (false full-speed end of reset indication).

Features of Various Embodiments of the Invention

- The eUSB device repeater adjusts its high-speed squelch detector threshold higher when host chirps are expected. This allows it to ignore the differential voltage on USB2 during SE0 due to the eUSB device repeater's pullup resistor on D+ in combination with the USB2 host/hub's high-speed termination. Because of this, the squelch detector can be relied upon to accurately reflect the presence of a high-speed signal (chirp) or not (SE0).

- Programmable Window Scheme. A programmable windowing scheme is proposed to break the USB2 bus reset into two windows to allow the eUSB device repeater to have fast reliable detection of the end of the USB2 reset given the possible error conditions described above.

  - Window 1 is meant to provide enough time for the host to send several chirps and for the repeater to detect at least one host chirp.

  - Window 2, following window 1, is meant to look for the actual end of reset. If a host chirp was not detected during window 1 then it is likely that the host is a full-speed host and the end of reset detection involves simply looking for a FS J condition. If a host chirp was detected during window 1, then the end of reset detection involves looking for the SE0 at the end of the USB2 bus reset.

  - Two options are presented for window timing.

Option 1 has a shorter window 1 time (~500μs) and a longer window 2 time (~2.5ms). This option allows us to quickly search for chirps and then start looking for the end of reset, but it involves a longer SE0 debounce. Option 2 has a longer window 1 time (~2.5ms) and a shorter window 2 time (~500μs). This option more closely matches the timing of a typical USB2 device. It allows for a much shorter SE0 debounce time to detect the end of reset.

- Various embodiments of the invention can implement a 3ms abort timer if the reset does not resolve to an 'end of reset' declaration within the expected time after a device chirp. This way, the eUSB device repeater will not get stuck waiting forever for the end of the reset. It will at least eventually abort and enter FS L0 state.

- End of Reset Pulse on eD+ can send a shortest pulse on eD+ to indicate end of reset to the eUSB device. By using a 500ns pulse, for example, this allows the time from the end of reset detection until the time the repeater enters its FS L0 state to be within 600ns to be compliant to the popular non-USB2 compliant USB2 FS Hubs. For example, the eUSB device repeater can include a single-ended eUSB signal receiver circuit to detect a pulse on the eD+ line.

Certain Operations of Various Embodiments of an eUSB Device Repeater

The eUSB device repeater, in various embodiments, can operate according to one or more of the following.

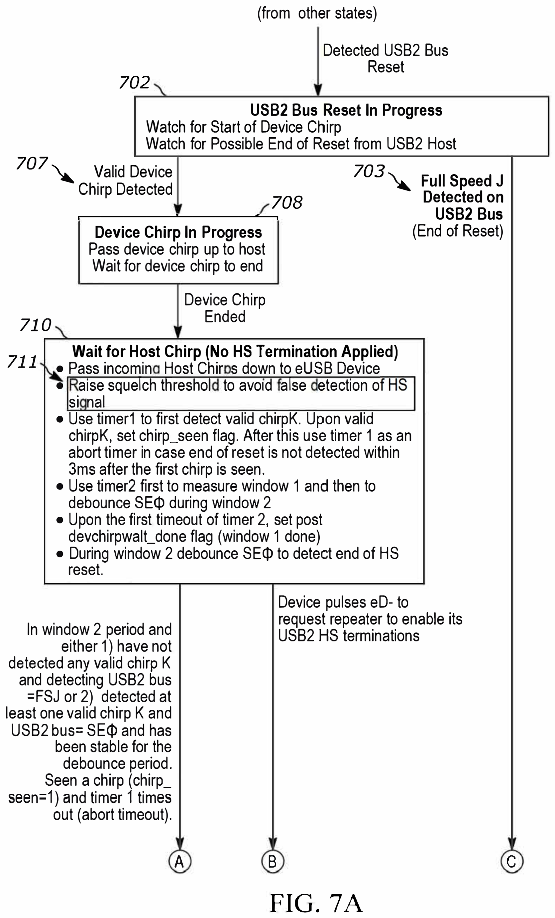

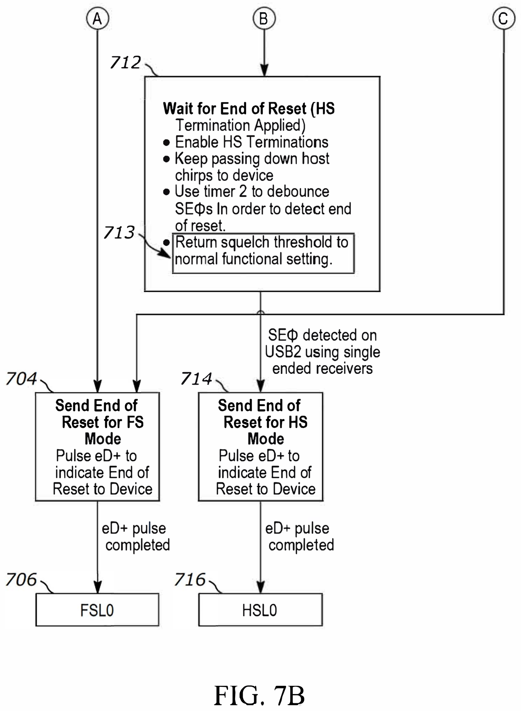

1) Raise the squelch threshold to a higher-than-normal level so that any differential voltage on USB2 bus due to the combination of the FS pullup on D+ and the HS termination from the host/hub will be ignored to allow detection of actual SE0 periods. Note that while the eUSB device repeater is in its "Wait for host chirps (no HS termination applied)" state 710 (see FIG. 7), it adjusts its USB2 HS receiver squelch threshold to a higher setting to avoid detecting a false high-speed signal level during the SE0 conditions. This makes detecting SE0 more reliable. So even though there may be a differential voltage due to the USB2 host/hub's high-speed termination combined with the eUSB device repeater's pullup on D+, the resulting voltage will be below the repeater's squelch detector voltage. This allows the eUSB device repeater to detect SE0 periods more accurately and reliably.

2) Break the reset detection by the eUSB device repeater into two windows, in which:

a) Window 1 does not look for the end of reset. The eUSB device repeater looks to find any presence of a host K chirp. Window 1 starts after the end of the device chirp and is a programmable duration such as 500μs, 2.5ms, etc.

b) Window 2 starts after window 1 and lasts until the end of the USB2 bus reset. The eUSB device repeater continues to look for the presence of host chirps, but now also looks for the end of the bus reset.

i) If the eUSB device repeater sees a FS J and has not seen a host chirp, then the eUSB device repeater knows that the reset is complete and it should transition to its FS L0 state.

ii) If the eUSB device repeater sees the eUSB device pulse eD+ to indicate valid host chirps were detected, then it enables its HS terminations and then looks for any SE0 condition to signify the end of the reset and transition to its HS L0 state.

iii) If the eUSB device has not pulsed its eD+ line but the eUSB device repeater has detected at least one host chirp K and then sees a prolonged SE0 (programmable length debounce) then it knows the reset is complete but with invalid host chirps (the eUSB device could not recognize valid host chirp sequence) and so the eUSB device repeater transitions to the FS L0 state.

iv) If the eUSB device repeater has not detected the end of reset and 3ms has passed since the end of the device chirp, then the eUSB device repeater aborts its operation and transitions to FS L0 state.

v) Otherwise, the eUSB device repeater keeps looking for the end of reset.

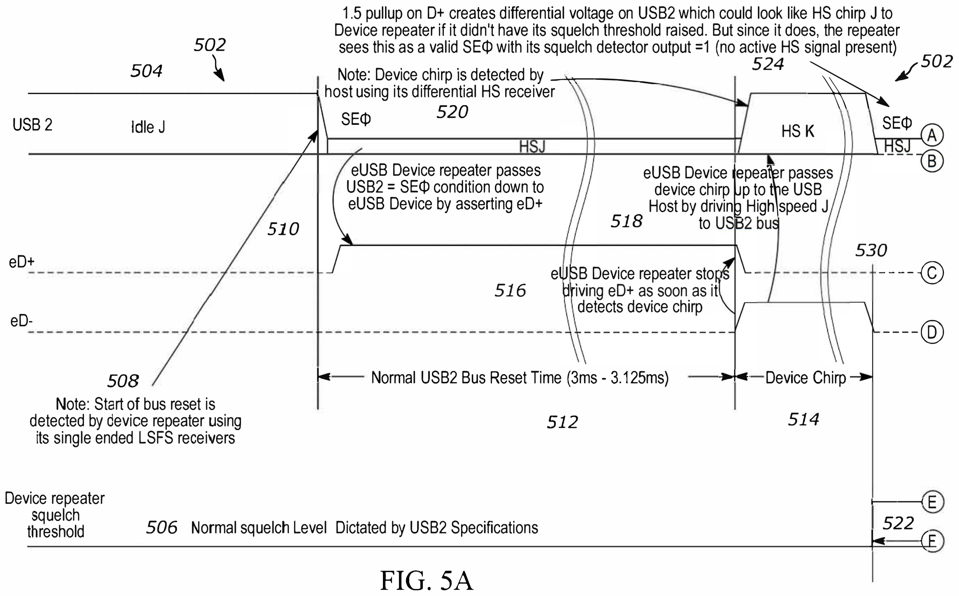

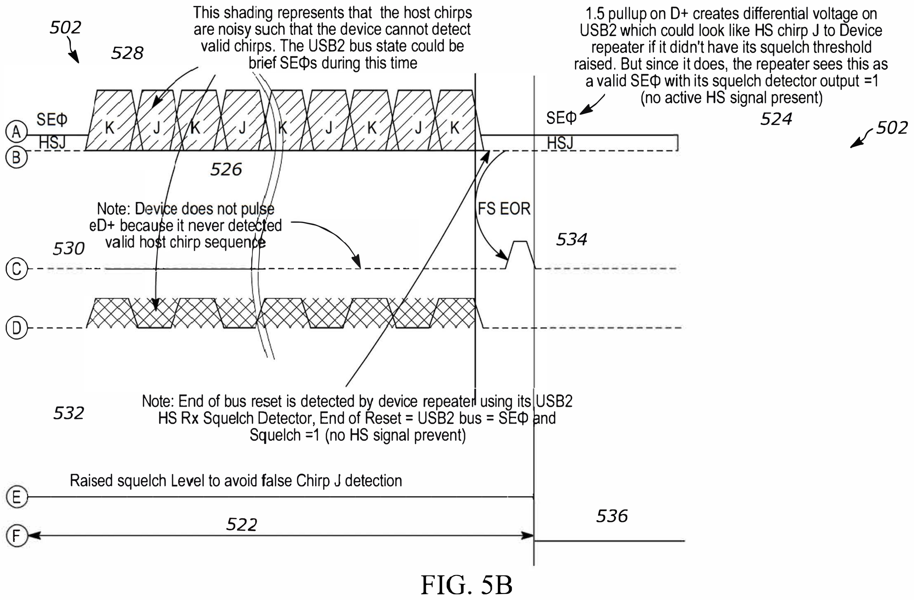

Examples of a USB2 End of Reset Detection Methods Are Shown in FIGs. 5, 6, and 7

FIGs. 5A and 5B illustrate an example of a USB2 bus reset sequence received by a receiver in an eUSB2 peripheral device repeater, such as shown in FIG. 1. The bus signaling illustrates the repeater, including a squelch detector circuit and a variable squelch level circuit as shown in FIG. 4, receiving noisy USB host chirp signals from a USB bus. FIGs. 5A and 5B show a USB bus reset with noisy host chirps 526. It shows the eUSB bus as well to illustrate that the device never pulses eD+, indicating that it never detected valid host chirps. The diagram includes indications of when the squelch threshold is raised from the normal squelch level 506 to a higher level 522 during the USB bus reset, and then at the end of the reset sequence, the squelch threshold is lowered back to the normal squelch level 536.

More specifically, the signal timing diagram 502 shows when USB2 bus is idle 504 and the device repeater squelch threshold is at the normal level 506 specified by the USB standard. The device repeater detects 508 the start of a USB bus reset when USB bus goes from idle to SE0 state. eUSB device repeater passes 510 the SE0 signal from the USB2 bus to the eUSB device by raising the eD+. The normal USB2 bus reset time 512 is shown. The eUSB device repeater stops asserting the eD+ 516 as soon as it detects a device chirp 514. The repeater passes the eUSB device chirp to the USB bus 520 and the host. At the end of the device chirp 514, the eUSB device repeater raises the squelch level 522. A 1.5KΩ pullup resistor on D+ create differential voltage on USB2 bus which could look like a high-speed chirp J to the device repeater. However, with the squelch threshold raised, the repeater sees this as a valid SE0 524. The host sends a series of K - J chirps 528, which due to noise on the USB bus 526 the repeater cannot detect valid chirps. The eUSB device also does not detect 530 valid chirps from the host. The eUSB device does not pulse eD+ because it never detected valid host chirps. An end of bus reset is detected by the eUSB device repeater 532. In response the eUSB device repeater pulses the FS EOR and then lowers 536 the squelch level threshold to the normal squelch level threshold.

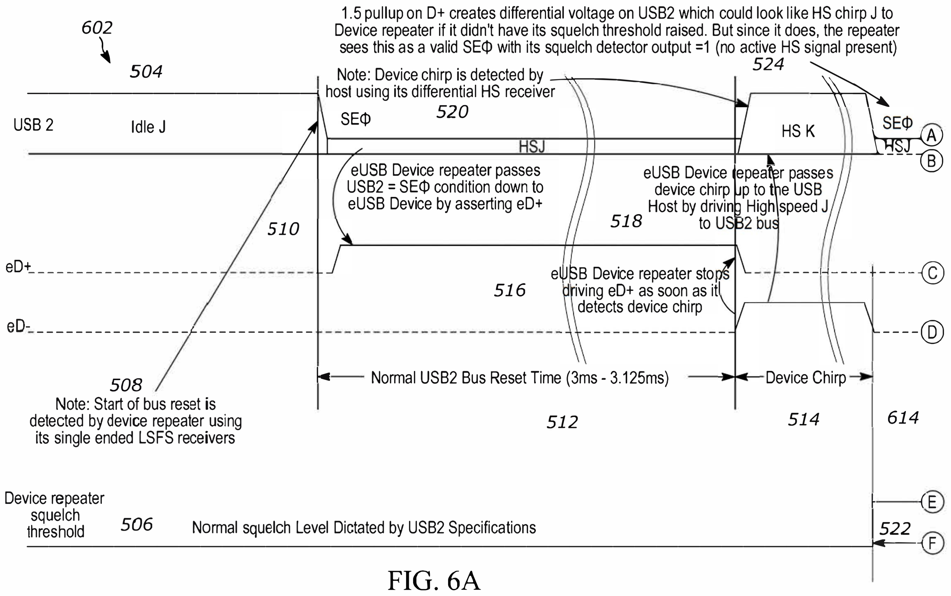

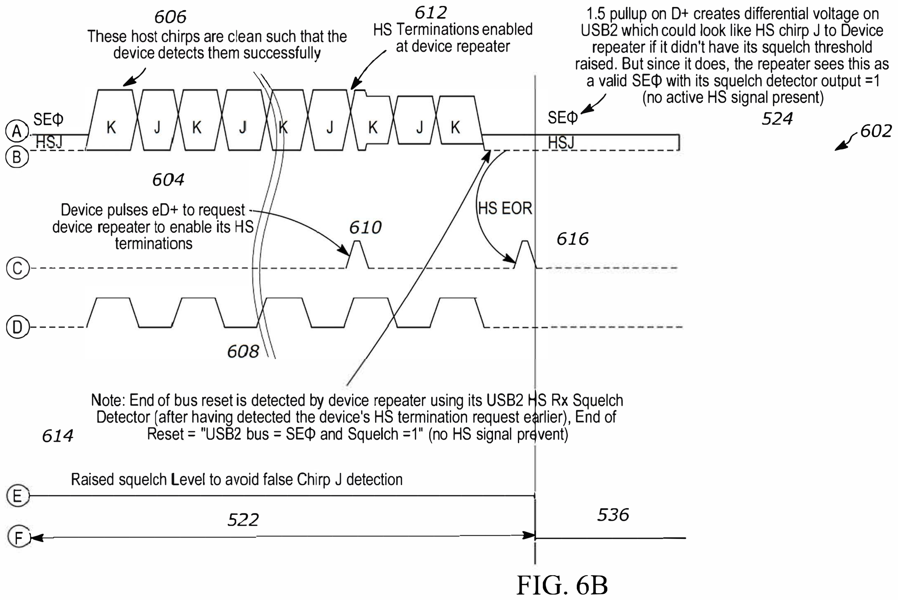

FIGs. 6A and 6B are a signal timing diagram 602 illustrating an example of a USB2 bus reset sequence similar to the example shown in FIGs. 5A and 5B. However, the bus signaling illustrates the eUSB2 peripheral device repeater receiving 606 clean host chirp signals 604 from the USB bus. The repeater passes to the eUSB device the host chirp signals 608 and the eUSB device pulses the eD+ line to request the repeater enable its high-speed terminations 610. The eUSB repeater enables 612 its HS terminations. The end of bus reset is detected by the device repeater 614 and in response pulses 616 the eUSB D+ line to signal the eUSB device the end of bus reset. The repeater then lowers 536 the squelch level to the normal squelch level.

FIGs. 7A and 7B illustrate three example operational sequences for the eUSB2 peripheral device repeater 120 configured with the novel variable squelch level circuit 404, 408, 410, 412. The eUSB device repeater detects 702 a possible end of reset signal from the USB2 host. If a full-speed J is detected 703 on the USB2 bus, the eUSB repeater pulses 704 the eD+ line to indicate end of reset in FS mode to the eUSB device 706.

According to a second alternative, the eUSB repeater, at step 702, detects a valid device chirp 707 and waits for the device chirp to end 708. After the device chirp has ended, at step 710, the eUSB repeater waits, at step 710, to receive a host chirp and raises the squelch threshold 711.

If the eUSB repeater detects any of the following then it will, at step 710, return the squelch threshold to a normal threshold level and pulse, at step 704, the eD+ line to indicate end of reset to the eUSB device.

1) Fails to detect any valid chirp K but is detecting USB2 bus being at the FS J level,

2) Did detect at least one valid chirp K and is detecting the USB2 bus being at the SE0 level for a debounce period, or

3) Did detect at least one valid chirp K but detects the abort timer timeout.

According to a third alternative operational sequence, continuing from step 710, the eUSB device pulses the eD+ line to request the eUSB repeater enable its USB2 HS terminations.

The eUSB repeater waits, at step 712, for end of reset with its HS terminations applied, and returns 713 the squelch threshold level to the normal threshold level. The eUSB repeater, at step 714, pulses the eD+ line to indicate end of reset in HS mode to the eUSB device 716.

An eUSB device repeater 120 comprises an eUSB transceiver 124 including: D+ and D- lines 130 for communicating USB signals via a USB bus electrically coupled to a USB host 104, and eD+ and eD- lines 134 for communicating signals via an eUSB bus 134 electrically coupled to an eUSB device 126. A squelch detector circuit 404 is electrically coupled to the D+ and D- lines for detecting a differential voltage therebetween and comparing it to a selectively variable squelch threshold voltage level at an input of the squelch detector circuit 404, and providing a squelch signal at an output of the squelch detector circuit based on the comparison. A selector circuit 412 has an output electrically coupled to the input of the squelch detector circuit thereby providing the selectively variable squelch threshold voltage level at the input of the squelch detector circuit, the selector circuit selecting and providing at its output the selectively variable squelch threshold voltage level based on one of a plurality of squelch threshold voltage levels 408.

A USB-capable device 106 comprises an eUSB device repeater 120 including: D+ and D- lines for communicating USB signals via a USB bus 130 electrically coupled to a USB host 104, and eD+ and eD- lines 134 for communicating USB signals via an eUSB bus 134 electrically coupled to an eUSB device 126. A squelch detector circuit 404 is electrically coupled to the D+ and D- lines for detecting a differential voltage therebetween and comparing it to a selectively variable squelch threshold voltage level at an input of the squelch detector circuit, and providing a squelch signal at an output of the squelch detector circuit based on the comparison. A selector circuit 412 has an output electrically coupled to the input of the squelch detector circuit thereby providing the selectively variable squelch threshold voltage level to the squelch detector circuit, the selector circuit providing at its output, and at the input to the squelch detector circuit, the selectively variable squelch threshold voltage level based on the selector circuit selecting one of a plurality of squelch threshold voltage levels 408. A state machine circuit 410 has an output electrically coupled to a selection input of the selector circuit, the state machine configured to provide a selection signal to the selection input of the selector circuit, which in response selects one of the plurality of squelch threshold voltage levels and provides the selectively variable squelch threshold voltage level to the input of the squelch detector circuit which provides the squelch signal to an input of the state machine.

A portable device comprises an eUSB device repeater, electrically coupled to the processor, including: D+ and D- lines for communicating USB signals via a USB bus electrically coupled to a USB host, and eD+ and eD- lines for communicating eUSB signals via an eUSB bus electrically coupled to an eUSB device. a squelch detector circuit electrically coupled to the D+ and D- lines for detecting a differential voltage therebetween and comparing it to a selectively variable squelch threshold voltage level at an input of the squelch detector circuit, and providing a squelch signal at an output of the squelch detector circuit based on the comparison, one squelch threshold voltage level being a chirp-specific squelch threshold voltage level that is a higher DC voltage than a normal squelch threshold voltage level. A state machine circuit is configured to select one squelch threshold voltage level and provide it to the input of the squelch detector circuit, which provides the squelch signal to the state machine, the squelch signal indicating to the state machine whether a valid J-chirp or a valid K-chirp is present on the USB bus. The eUSB device repeater includes a single-ended USB signal receiver circuitry electrically coupled to the D+ line, and separately to the D- line, of the USB bus for detecting a valid SE0 state on the USB bus, and determining a start of a USB bus reset based on detecting a valid SE0 state on the USB bus. The state machine is configured to divide a USB2 bus reset sequence into two windows, in which:

Window 1: the first window starts after the eUSB device repeater determines a start of a USB bus reset and the completion of a device chirp. The first window continues with the state machine providing a chirp-specific squelch threshold voltage level at the input of the squelch detector circuit. The first window ends after a programmable period of time (e.g., $500\mu s$).

Window 2: the second window starts after the first window, and continues with the eUSB device repeater still monitoring for valid host chirps on the USB bus. The second window ends with the eUSB device repeater detecting no host chirp on the USB bus for a defined time period detecting a valid SE0 on the USB bus or an abort timeout occurs in which no end of reset was detected within an error timeout window.

One or more embodiments of the present disclosure may include features recited in the following numbered clauses:

1. An eUSB device repeater comprising: an eUSB transceiver including: D+ and D-lines for communicating USB signals via a USB bus electrically coupled to a USB host, and eD+ and eD- lines for communicating signals via an eUSB bus electrically coupled to an eUSB device; a squelch detector circuit electrically coupled to the D+ and D- lines for detecting a differential voltage therebetween and comparing it to a selectively variable squelch threshold voltage level at an input of the squelch detector circuit, and providing a squelch signal at an output of the squelch detector circuit based on the comparison; and a selector circuit having an output electrically coupled to the input of the squelch detector circuit thereby providing the selectively variable squelch threshold voltage level at the input of the squelch detector circuit, the selector circuit selecting and providing at its output the selectively variable squelch threshold voltage level based on one of a plurality of squelch threshold voltage levels.

2. The eUSB device repeater of claim 1, further comprising a squelch threshold voltage generating circuit that outputs the plurality of squelch threshold voltage levels at a respective plurality of outputs of the squelch threshold voltage generating circuit, the plurality of outputs are electrically connected to a respective plurality of squelch threshold voltage level inputs of the selector circuit, the selector circuit providing at its output, and at the input to the squelch detector circuit, the selectively variable squelch threshold voltage level based on the selector circuit selecting one of the plurality of squelch threshold voltage levels at one of its inputs.

3. The eUSB device repeater of claim 2, wherein the selector circuit provides at its output a normal squelch threshold voltage level that complies with the USB2 standard, based on a selected one of the plurality of squelch threshold voltage levels generated by the squelch threshold voltage generating circuit at one of the plurality of squelch threshold voltage level inputs of the selector circuit, and thereby the normal squelch threshold voltage level is provided to the input of the squelch detector circuit.

4. The eUSB device repeater of claim 2, wherein the selector circuit provides at its output a normal squelch threshold voltage level that complies with the USB2 standard, or a chirp-specific squelch threshold voltage level that is a higher DC voltage than the normal squelch threshold voltage level, based on the selector circuit selecting one of the plurality of squelch threshold voltage levels generated by the squelch threshold voltage generating circuit at one of the plurality of squelch threshold voltage level inputs of the selector circuit.

5. The eUSB device repeater of claim 2, further comprising a state machine circuit having an output electrically coupled to a selection input of the selector circuit, the state machine configured to provide a selection signal at its output and thereby to the selection input of the selector circuit which in response selects one of the squelch threshold voltage level inputs of the selector circuit and provides the selectively variable squelch threshold voltage level at an output of the selector circuit, and at the input of the squelch detector circuit, based on the selected one of the plurality of squelch threshold voltage level inputs of the selector circuit.

6. The eUSB device repeater of claim 5, wherein the squelch signal indicates to the state machine whether a valid J-chirp or a valid K-chirp is present on the USB bus, and wherein the eUSB device repeater includes a single-ended USB signal receiver electrically coupled to the D+ line and a single-ended USB signal receiver electrically coupled to the D-line, of the USB bus for detecting a valid SE0 state present on the USB bus, the eUSB device repeater determining a start of a USB bus reset based on the eUSB device repeater detecting a valid SE0 state on the USB bus, and during a USB bus reset the state machine providing a selection signal to the input of the selector circuit thereby providing to the input of the squelch detector circuit a chirp-specific squelch threshold voltage level that is a higher DC voltage than a normal squelch threshold voltage level that complies with the USB2 standard, and thereby the squelch signal from the output of the squelch detector circuit indicates to the state machine no valid J-chirp or valid K-chirp is present on the USB bus during an SE0 portion of the USB bus reset, and contemporaneously the eUSB device repeater detecting a valid SE0 on the USB bus.

7. The eUSB device repeater of claim 1, wherein the eUSB device repeater is configured to support USB2 communications over a USB2 bus and eUSB2 communications over an eUSB2 bus, according to the USB 2.0 standard.

8. The eUSB device repeater of claim 1, wherein the eUSB transceiver is configured to support USB communications over a USB bus according to multiple USB standards, including any one or more of USB 2.0 or USB 3.x.

9. The eUSB device repeater of claim 1, wherein the eUSB transceiver is configured to support eUSB communications over an eUSB bus according to multiple eUSB standards, including any one or more of eUSB 2.0 or eUSB 3.x.

10. The eUSB device repeater of claim 1, wherein the eUSB device repeater is configured to selectively operate as one of a USB device role or a USB host role.

11. A USB-capable device comprising: an eUSB device repeater including: D+ and D-lines for communicating USB signals via a USB bus electrically coupled to a USB host, and eD+ and eD- lines for communicating USB signals via an eUSB bus electrically coupled to an eUSB device; and a squelch detector circuit electrically coupled to the D+ and D-lines for detecting a differential voltage therebetween and comparing it to a selectively variable squelch threshold voltage level at an input of the squelch detector circuit, and providing a squelch signal at an output of the squelch detector circuit based on the comparison; a selector circuit having an output electrically coupled to the input of the squelch detector circuit thereby providing the selectively variable squelch threshold voltage level to the squelch detector circuit, the selector circuit providing at its output, and at the input to the squelch detector circuit, the selectively variable squelch threshold voltage level based on the selector circuit selecting one of a plurality of squelch threshold voltage levels; and a state machine circuit having an output electrically coupled to a selection input of the selector circuit, the state machine circuit configured to provide a selection signal to the selection input of the selector circuit, which in response selects one of the plurality of squelch threshold voltage levels and provides the selectively variable squelch threshold voltage level to the input of the squelch detector circuit which provides the squelch signal to an input of the state machine.

12. The USB-capable device of claim 11, wherein the squelch signal indicates to the state machine whether a valid J-chirp or a valid K-chirp is present on the USB bus; and wherein the eUSB device repeater includes a single-ended USB signal receiver circuit that includes a single-ended USB signal receiver electrically coupled to the D+ line and a single-ended USB signal receiver electrically coupled to the D- line, of the USB bus for detecting a valid SE0 state present on the USB bus, the eUSB device repeater determining a start of a USB bus reset based on the eUSB device repeater detecting a valid SE0 state on the USB bus.

13. The USB-capable device of claim 12, wherein the single-ended USB signal receiver circuit is electrically coupled to the state machine circuit, and based on the state machine receiving an information signal from the single-ended USB signal receiver circuit the state machine determining a valid SE0 state on the USB bus; and wherein the eUSB device repeater determining a start of a USB bus reset based on the state machine detecting a valid SE0 state on the USB bus, and during a USB bus reset the state machine providing a selection signal to the input of the selector circuit thereby providing to the input of the squelch detector circuit a chirp-specific squelch threshold voltage level that is a higher DC voltage than a normal squelch threshold voltage level that complies with the USB standard, and thereby the squelch signal from the output of the squelch detector circuit indicating to the state machine no valid J-chirp or valid K-chirp is present on the USB bus, and contemporaneously the eUSB device repeater detecting a valid SE0 state on the USB bus.

14. The USB-capable device of claim 13, further comprising: a single-ended eUSB signal receiver circuit electrically coupled to the eD+ line of the eUSB bus for the eUSB device repeater detecting a pulse on the eD+ line; and wherein the state machine circuit provides a selection signal to the input of the selector circuit, thereby providing to the input of the squelch detector circuit a normal squelch threshold voltage level that complies with the USB standard, based on the eUSB device repeater detecting a pulse on the eD+ line contemporaneous with determining a valid SE0 state on the USB bus during a USB bus reset.

15. The USB-capable device of claim 11, wherein the USB-capable device comprises at least one of: a portable device, mobile phone, a PC, a USB hub, an external storage device, a modem, a mouse, a keyboard, or any combination thereof.

16. The USB-capable device of claim 11, wherein the eUSB device repeater is configured to support USB2 communications over a USB2 bus and eUSB2 communications over an eUSB2 bus, according to the USB 2.0 and the eUSB 2.0 standards.

17. The USB-capable device of claim 11, wherein the eUSB device repeater is configured to support USB communications over a USB bus according to multiple USB standards, including any one or more of USB 2.0 or USB 3.x.

18. The USB-capable device of claim 11, wherein the eUSB device repeater is configured to selectively operate as one of a USB device role or a USB host role.

19. The USB-capable device of claim 11, wherein the state machine circuit is configured to select a squelch threshold voltage level and provide it to the input of the squelch detector circuit, the selected squelch threshold voltage level being a chirp-specific squelch threshold voltage level that is a higher DC voltage than a normal squelch threshold voltage level, and during a USB bus reset sequence the squelch signal indicating to the state machine circuit whether a valid J-chirp or a valid K-chirp is present on the USB bus.

20. A portable device comprising: an eUSB device repeater, including: D+ and D- lines for communicating USB signals via a USB bus electrically coupled to a USB host, and eD+ and eD- lines for communicating eUSB signals via an eUSB bus electrically coupled to an eUSB device; and a squelch detector circuit electrically coupled to the D+ and D- lines for detecting a differential voltage therebetween and comparing it to a selectively variable squelch threshold voltage level at an input of the squelch detector circuit, and providing a squelch signal at an output of the squelch detector circuit based on the comparison, one squelch threshold voltage level being a chirp-specific squelch threshold voltage level that is a higher DC voltage than a normal squelch threshold voltage level; and a state machine circuit configured to select one squelch threshold voltage level and provide it to the input of the squelch detector circuit, which provides the squelch signal to the state machine, the squelch signal indicating to the state machine whether a valid J-chirp or a valid K-chirp is present on the USB bus, wherein the eUSB device repeater includes a single-ended USB signal receiver circuitry electrically coupled to the D+ line, and separately to the D- line, of the USB bus for detecting a valid SE0 state on the USB bus, and determining a start of a USB bus reset based on detecting a valid SE0 state on the USB bus, and wherein the state machine is configured to divide a USB2 bus reset sequence into two windows, a first window starting after the eUSB device repeater determining a start of a USB bus reset and detecting completion of a device chirp, and the first window continuing with the state machine providing a chirp-specific squelch threshold voltage level at the input of the squelch detector circuit, and the first window ending after a programmable period of time; and a second window starting after the first window, and continuing with the eUSB device repeater still monitoring for valid host chirps on the USB bus, and the second window ending with the eUSB device repeater detecting the end of the USB bus reset or an abort timeout occurs in which no end of reset was detected within an error timeout window.

## Non-Limiting Examples

The present invention may be implemented as a system and/or a method at any possible technical detail level of integration. A computer program may include computer-readable program instructions to allow a processor to carry out aspects of the present invention.

Computer-readable program instructions for carrying out operations of the present invention may be assembler instructions, instruction-set-architecture (ISA) instructions, machine instructions, machine-dependent instructions, microcode, firmware instructions, state-setting data, configuration data for integrated circuitry, or either source code or object code written in any combination of one or more programming languages. The computer-readable program instructions may execute entirely as a stand-alone software package. In some embodiments, electronic circuitry including, for example, state machine circuitry, application specific integrated circuit (ASIC), programmable logic circuitry, field-programmable gate arrays (FPGA), or programmable logic arrays (PLA) may execute the computer readable program instructions by utilizing state information of the computer readable program instructions to customize the electronic circuitry, in order to perform aspects of the present invention.

Aspects of the present invention are described herein with reference to flow diagram illustrations and/or block diagrams of methods, apparatus (systems), state machines, electronic circuitry, and computer programs, according to various embodiments. It will be understood that each block of the flow diagram illustrations and/or block diagrams, and combinations of blocks in the flow diagram illustrations and/or block diagrams, can be implemented by any one or more of computer-readable program instructions, electronic circuitry, state machines, application specific integrated circuit (ASIC), programmable logic circuitry, field-programmable gate arrays (FPGA), or programmable logic arrays (PLA), and computer programs, and the like.

In some alternative implementations, the functions noted in the blocks may occur out of the order noted in the Figures. For example, two blocks shown in succession may be executed substantially concurrently, or the blocks may sometimes be executed in the reverse order, depending upon the functionality involved.

Although the present specification may describe components and functions implemented in the embodiments with reference to particular standards and protocols, the invention is not limited to such standards and protocols. Each of the standards represents examples of the state of the art. Such standards are from time-to-time superseded by faster or more efficient equivalents having essentially the same functions.

The illustrations of examples described herein are intended to provide a general understanding of the structure of various embodiments, and they are not intended to serve as a complete description of all the elements and features of apparatus and systems that might use the structures described herein. Upon reviewing the above description, many other embodiments will be apparent to those of ordinary skill in the art. Other embodiments may be utilized and derived therefrom, such that structural and logical substitutions and changes may be made without departing from the scope of this invention. Figures are also merely representational and may not be drawn to scale. Certain proportions thereof may be exaggerated, while others may be minimized. Accordingly, the specification and drawings should be regarded in an illustrative rather than a restrictive sense.

The Abstract is provided with the understanding that it is not intended to be used to interpret or limit the scope or meaning of the claims. In addition, in the foregoing Detailed Description, various features are grouped in a single example embodiment to streamline the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are incorporated into the Detailed Description, with each claim standing on its own as a separately claimed subject matter.

The terminology used herein is to describe particular embodiments only and is not intended to be limiting to the invention. As used herein, the singular forms "a", "an" and "the" are intended to include the plural forms as well unless the context clearly indicates otherwise. It will be further understood that the terms "comprises" and/or "comprising," when used in this specification, specify the presence of stated features, integers, steps, operations, elements, and/or components but do not preclude the presence or addition of one or more other features, integers, steps, operations, elements, components, and/or groups thereof. The term "another", as used herein, is defined as at least a second or more. The terms "including" and "having," as used herein, are defined as comprising (i.e., open language). The term "coupled," as used herein, is defined as "connected," although not necessarily directly and not necessarily mechanically. "Communicatively coupled" refers to the coupling of components such that these components can communicate with one another through, for example, wired, wireless or other communications media. The terms "communicatively coupled" or "communicatively coupling" include, but are not limited to, communicating electronic control signals by which one element may direct or control another. The term "configured to" describes hardware, software or a combination of hardware and software that is set up, arranged, built, composed, constructed, designed or that has any combination of these characteristics to carry out a given function. The term "adapted to" describes hardware, software, or a combination of hardware and software that can accommodate, make, or be suitable to carry out a given function.

The terms "controller", "computer", "processor", "server", "client", "computer system", "computing system", "personal computing system", "processing system", or "information processing system", describe examples of a suitably configured processing system adapted to implement one or more embodiments herein. A processing system may include one or more processing systems or processors. A processing system can be realized in a centralized fashion in one processing system or in a distributed fashion where different elements are spread across several interconnected processing systems.

The corresponding structures, materials, acts, and equivalents of all means or step plus function elements in the claims below are intended to include any structure, material, or act for performing the function in combination with other claimed elements as specifically claimed.

The description of the present application has been presented for illustration and description but is not intended to be exhaustive or limited to the invention in the form disclosed. Many modifications and variations will be apparent to those of ordinary skill in the art without departing from the scope of the invention. The embodiments were chosen and described to explain best the principles of the invention and the practical applications, and to enable others of ordinary skill in the art to understand the invention for various embodiments with various modifications suited to the particular use contemplated.

**Claims**

1. An eUSB device repeater comprising:

   an eUSB transceiver including:

      D+ and D- lines for communicating USB signals via a USB bus electrically coupled to a USB host, and
      eD+ and eD- lines for communicating signals via an eUSB bus electrically coupled to an eUSB device;

      a squelch detector circuit electrically coupled to the D+ and D- lines for detecting a differential voltage therebetween and comparing it to a selectively variable squelch threshold voltage level at an input of the squelch detector circuit, and providing a squelch signal at an output of the squelch detector circuit based on the comparison; and
      a selector circuit having an output electrically coupled to the input of the squelch detector circuit thereby providing the selectively variable squelch threshold voltage level at the input of the squelch detector circuit, the selector circuit selecting and providing at its output the selectively variable squelch threshold voltage level based on one of a plurality of squelch threshold voltage levels.

2. The eUSB device repeater of claim 1, further comprising a squelch threshold voltage generating circuit that outputs the plurality of squelch threshold voltage levels at a respective plurality of outputs of the squelch threshold voltage generating circuit, the plurality of outputs are electrically connected to a respective plurality of squelch threshold voltage level inputs of the selector circuit, the selector circuit providing at its output, and at the input to the squelch detector circuit, the selectively variable squelch threshold voltage level based on the selector circuit selecting one of the plurality of squelch threshold voltage levels at one of its inputs.

3. The eUSB device repeater of claim 2, wherein the selector circuit provides at its output a normal squelch threshold voltage level that complies with the USB2 standard, based on a selected one of the plurality of squelch threshold voltage levels generated by the squelch threshold voltage generating circuit at one of the plurality of squelch threshold voltage level inputs of the selector circuit, and thereby the normal squelch threshold voltage level is provided to the input of the squelch detector circuit.

4. The eUSB device repeater of claim 2, wherein the selector circuit provides at its output

   a normal squelch threshold voltage level that complies with the USB2 standard, or
   a chirp-specific squelch threshold voltage level that is a higher DC voltage than the normal squelch threshold voltage level,

   based on the selector circuit selecting one of the plurality of squelch threshold voltage levels generated by the squelch threshold voltage generating circuit at one of the plurality of squelch threshold voltage level inputs of the selector circuit.

5. The eUSB device repeater of any of claims 2 to 4, further comprising a state machine circuit having an output electrically coupled to a selection input of the selector circuit, the state machine configured to provide a selection signal at its output and thereby to the selection input of the selector circuit which in response selects one of the squelch threshold voltage level inputs of the selector circuit and provides the selectively variable squelch threshold voltage level at an output of the selector circuit, and at the input of the squelch detector circuit, based on the selected one of the plurality of squelch threshold voltage level inputs of the selector circuit.

6. The eUSB device repeater of claim 5, wherein the squelch signal indicates to the state machine whether a valid J-chirp or a valid K-chirp is present on the USB bus, and

wherein the eUSB device repeater includes a single-ended USB signal receiver electrically coupled to the D+ line and a single-ended USB signal receiver electrically coupled to the D- line, of the USB bus for detecting a valid SE0 state present on the USB bus, the eUSB device repeater determining a start of a USB bus reset based on the eUSB device repeater detecting a valid SE0 state on the USB bus, and during a USB bus reset the state machine providing a selection signal to the input of the selector circuit thereby providing to the input of the squelch detector circuit a chirp-specific squelch threshold voltage level that is a higher DC voltage than a normal squelch threshold voltage level that complies with the USB2 standard, and thereby the squelch signal from the output of the squelch detector circuit indicates to the state machine no valid J-chirp or valid K-chirp is present on the USB bus during an SE0 portion of the USB bus reset, and contemporaneously the eUSB device repeater detecting a valid SE0 on the USB bus.

7. The eUSB device repeater of any of claims 1 to 8, wherein the eUSB device repeater is configured to support USB2 communications over a USB2 bus and eUSB2 communications over an eUSB2 bus, according to the USB 2.0 standard.

8. The eUSB device repeater of any of claims 1 to 7, wherein the eUSB transceiver is configured to support USB communications over a USB bus according to multiple USB standards, including any one or more of USB 2.0 or USB 3.x.

9. The eUSB device repeater of any of claims 1 to 8, wherein the eUSB transceiver is configured to support eUSB communications over an eUSB bus according to multiple eUSB standards, including any one or more of eUSB 2.0 or eUSB 3.x.

10. The eUSB device repeater of any of claims 1 to 9, wherein the eUSB device repeater is configured to selectively operate as one of a USB device role or a USB host role.

11. A USB-capable device comprising:

an eUSB device repeater including:

D+ and D- lines for communicating USB signals via a USB bus electrically coupled to a USB host, and
eD+ and eD- lines for communicating USB signals via an eUSB bus electrically coupled to an eUSB device; and

a squelch detector circuit electrically coupled to the D+ and D- lines for detecting a differential voltage therebetween and comparing it to a selectively variable squelch threshold voltage level at an input of the squelch detector circuit, and providing a squelch signal at an output of the squelch detector circuit based on the comparison;

a selector circuit having an output electrically coupled to the input of the squelch detector circuit thereby providing the selectively variable squelch threshold voltage level to the squelch detector circuit, the selector circuit providing at its output, and at the input to the squelch detector circuit, the selectively variable squelch threshold voltage level based on the selector circuit selecting one of a plurality of squelch threshold voltage levels; and

a state machine circuit having an output electrically coupled to a selection input of the selector circuit, the state machine circuit configured to provide a selection signal to the selection input of the selector circuit, which in response selects one of the plurality of squelch threshold voltage levels and provides the selectively variable squelch threshold voltage level to the input of the squelch detector circuit which provides the squelch signal to an input of the state machine.

12. The USB-capable device of claim 11, wherein the squelch signal indicates to the state machine whether a valid J-chirp or a valid K-chirp is present on the USB bus; and

wherein the eUSB device repeater includes a single-ended USB signal receiver circuit that includes a single-ended USB signal receiver electrically coupled to the D+ line and a single-ended USB signal receiver electrically coupled to the D- line, of the USB bus for detecting a valid SE0 state present on the USB bus, the eUSB device repeater determining a start of a USB bus reset based on the eUSB device repeater detecting a valid SE0 state on the USB bus.

13. The USB-capable device of claim 11 or 12, wherein the single-ended USB signal receiver circuit is electrically coupled to the state machine circuit, and based on the state machine receiving an information signal from the single-ended USB signal receiver circuit the state machine determining a valid SE0 state on the USB bus; and wherein the eUSB device repeater determining a start of a USB bus reset based on the state machine detecting a valid SE0 state on the USB bus, and during a USB bus reset the state machine providing a selection signal to the input of the selector circuit thereby providing to the input of the squelch detector circuit a chirp-specific squelch threshold voltage level that is a higher DC voltage than a normal squelch threshold voltage level that complies with the USB standard, and thereby the squelch signal from the output of the squelch detector circuit indicating to the state machine no valid J-chirp or valid K-chirp is present on the USB bus, and contemporaneously the eUSB device repeater detecting a valid SE0 state on the USB bus.

14. The USB-capable device of claim 13, further comprising:

   a single-ended eUSB signal receiver circuit electrically coupled to the eD+ line of the eUSB bus for the eUSB device repeater detecting a pulse on the eD+ line; and
   wherein the state machine circuit provides a selection signal to the input of the selector circuit, thereby providing to the input of the squelch detector circuit a normal squelch threshold voltage level that complies with the USB standard, based on the eUSB device repeater detecting a pulse on the eD+ line contemporaneous with determining a valid SE0 state on the USB bus during a USB bus reset.

15. A portable device comprising:

   an eUSB device repeater, including:

      D+ and D- lines for communicating USB signals via a USB bus electrically coupled to a USB host, and
      eD+ and eD- lines for communicating eUSB signals via an eUSB bus electrically coupled to an eUSB device; and

   a squelch detector circuit electrically coupled to the D+ and D- lines for detecting a differential voltage therebetween and comparing it to a selectively variable squelch threshold voltage level at an input of the squelch detector circuit, and providing a squelch signal at an output of the squelch detector circuit based on the comparison, one squelch threshold voltage level being a chirp-specific squelch threshold voltage level that is a higher DC voltage than a normal squelch threshold voltage level; and
   a state machine circuit configured to select one squelch threshold voltage level and provide it to the input of the squelch detector circuit, which provides the squelch signal to the state machine, the squelch signal indicating to the state machine whether a valid J-chirp or a valid K-chirp is present on the USB bus,
   wherein the eUSB device repeater includes a single-ended USB signal receiver circuitry electrically coupled to the D+ line, and separately to the D- line, of the USB bus for detecting a valid SE0 state on the USB bus, and determining a start of a USB bus reset based on detecting a valid SE0 state on the USB bus, and
wherein the state machine is configured to divide a USB2 bus reset sequence into two windows,

   a first window starting after the eUSB device repeater determining a start of a USB bus reset and detecting completion of a device chirp, and the first window continuing with the state machine providing a chirp-specific squelch threshold voltage level at the input of the squelch detector circuit, and the first window ending after a programmable period of time; and
   a second window starting after the first window, and continuing with the eUSB device repeater still monitoring for valid host chirps on the USB bus, and the second window ending with the eUSB device repeater detecting the end of the USB bus reset or an abort timeout occurs in which no end of reset was detected within an error timeout window.

FIG. 1

EP 4 764 877 A1

## Table 3-2: eUSB2 High-Speed Bus State Representations

| Bus State | | At the source | At the sink | |
|---|---|---|---|---|
| Differential '1' | Terminated | VTX_DIF > VTX_DIF_TERM(Min) | VRX_DIF > VSQUELCH_DIF(MaX) | ~204 |
| | Unterminated | VTX_DIF > VTX_DIF_UNTERM(Min) | | |
| Differential '0' | Terminated | VTX_DIF < -VTX_DIF_TERM(Min) | VRX_DIF < -VSQUELCH_DIF(MaX) | ~206 |
| | Unterminated | VTX_DIF < -VTX_DIF_UNTERM(Min) | | |
| Squelch state | | NA | AC:<br>VRX_DIF < VSQUELCH_DIF(Min)<br>VRX_DIF > -VSQUELCH_DIF(Min) | ~208 |
| Data J state: | | Differential '1' | | |
| Data K state: | | Differential '0' | | |

FIG. 2

302

## Table 7-3: High-Speed Receiver DC Specifications

| Parameter | Symbol | Min | Typ | Max | Units |
|---|---|---|---|---|---|
| Squelch detect threshold (peak differential) | VSQUELCH_DIF | 60 | | 110 | mV |

FIG. 3

FIG. 4

1.5 pullup on D+ creates differential voltage on USB2 which could look like HS chirp J to Device repeater if it didn't have its squelch threshold raised. But since it does, the repeater sees this as a valid SEΦ with its squelch detector output =1 (no active HS signal present)

Note: Device chirp is detected by host using its differential HS receiver

eUSB Device repeater passes USB2 = SEΦ condition down to eUSB Device by asserting eD+

eUSB Device repeater passes device chirp up to the USB Host by driving High speed J to USB2 bus

eUSB Device repeater stops driving eD+ as soon as it detects device chirp

USB 2    Idle J    SEΦ    HSJ    HS K    SEΦ    (A)    HSJ    (B)

eD+ ....................................................... (C)

eD- ....................................................... (D)

Normal USB2 Bus Reset Time (3ms - 3.125ms)    Device Chirp

Note: Start of bus reset is detected by device repeater using its single ended LSFS receivers

Device repeater squelch threshold    Normal squelch Level  Dictated by USB2 Specifications    (E)    (E)

FIG. 5A

FIG. 5B

FIG. 6A

EP 4 764 877 A1

FIG. 6B

(from other states)

Detected USB2 Bus
Reset

*702*

**USB2 Bus Reset In Progress**
Watch for Start of Device Chirp
Watch for Possible End of Reset from USB2 Host

*707* Valid Device
Chirp Detected

*703* **Full Speed J
Detected on
USB2 Bus**
(End of Reset)

*708*

**Device Chirp In Progress**
Pass device chirp up to host
Wait for device chirp to end

Device Chirp
Ended

*710*

*711*

**Wait for Host Chirp (No HS Termination Applied)**
- Pass incoming Host Chirps down to eUSB Device
- Raise squelch threshold to avoid false detection of HS signal
- Use timer1 to first detect valid chirpK. Upon valid chirpK, set chirp_seen flag. After this use timer 1 as an abort timer in case end of reset is not detected within 3ms after the first chirp is seen.
- Use timer2 first to measure window 1 and then to debounce SEφ during window 2
- Upon the first timeout of timer 2, set post devchirpwalt_done flag (window 1 done)
- During window 2 debounce SEφ to detect end of HS reset.

In window 2 period and either 1) have not detected any valid chirp K and detecting USB2 bus =FSJ or 2) detected at least one valid chirp K and USB2 bus= SEφ and has been stable for the debounce period. Seen a chirp (chirp_ seen=1) and timer 1 times out (abort timeout).

Device pulses eD- to request repeater to enable its USB2 HS terminations

(A)    (B)    (C)

FIG. 7A

Ⓐ       Ⓑ       Ⓒ

712

**Wait for End of Reset (HS**
Termination Applied)
- Enable HS Terminations
- Keep passing down host chirps to device
- Use timer 2 to debounce SEΦs In order to detect end of reset.

713

- Return squelch threshold to normal functional setting.

SEΦ detected on
USB2 using single
ended receivers

704

**Send End of
Reset for FS
Mode**
Pulse eD+ to
indicate End of
Reset to Device

714

**Send End of
Reset for HS
Mode**
Pulse eD+ to
indicate End of
Reset to Device

eD+ pulse
completed

eD+ pulse
completed

706

FSL0

716

HSL0

FIG. 7B

| | Europäisches Patentamt<br>European Patent Office<br>Office européen des brevets | **EUROPEAN SEARCH REPORT** | **Application Number**<br>EP 25 21 6346 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2024/030545 A1 (TEXAS INSTRUMENTS INC [US]) 8 February 2024 (2024-02-08)<br>* the whole document *<br>----- | 1-15 | INV.<br>G06F13/40 |
| Y | Anonymous: "Multiplexer -Wikipedia",<br>,<br>12 January 2021 (2021-01-12), pages 1-7,<br>XP093144628,<br>Retrieved from the Internet:<br>URL:https://en.wikipedia.org/w/index.php?title=Multiplexer&oldid=999989492<br>[retrieved on 2024-03-22]<br>* page 1 *<br>----- | 2,5 | |
| Y | US 2011/131356 A1 (DEVAM MAYANK [IN] ET AL) 2 June 2011 (2011-06-02)<br>* paragraph [0037] *<br>----- | 6 | |
| A | JAMES GULA: "Embedded USB2 (eUSB2) Physical",<br>IEEE DRAFT WGDS; 859555112285 IEEE-SA IMEET CENTRAL, PISCATAWAY, NJ USA,<br>vol. 2030.1, 20 February 2019 (2019-02-20), pages 1-105, XP068236990,<br>[retrieved on 2023-07-19]<br>* the whole document *<br>----- | 1-15 | TECHNICAL FIELDS SEARCHED (IPC)<br><br>G06F |
| | -/-- | | |

The present search report has been drawn up for all claims

| Place of search | Date of completion of the search | Examiner |
|---|---|---|
| Munich | 21 April 2026 | Ghidini, Mario |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches
Patentamt

European
Patent Office

Office européen
des brevets

## EUROPEAN SEARCH REPORT

**Application Number**

EP 25 21 6346

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (IPC) |
| X | Anonymous: "PTN3222 1-port eUSB2 to USB2 redriver", , 11 August 2023 (2023-08-11), pages 1-55, XP093389432, Retrieved from the Internet: URL:https://www.nxp.com/docs/en/data-sheet /PTN3222_CUK.pdf [retrieved on 2026-04-20] | 1,10 | |
| Y | * page 1 * * page 6 * * page 15 * ----- | 2,5,6 | |
| X | EP 3 944 090 A1 (NXP BV [NL]) 26 January 2022 (2022-01-26) | 1,3,4, 7-15 | |
| Y | * paragraph [0003] * * paragraph [0026] - paragraph [0027]; figure 5 * * paragraph [0025]; figure 4 * ----- | 2,5,6 | |
| | | | TECHNICAL FIELDS SEARCHED (IPC) |

The present search report has been drawn up for all claims

| Place of search | Date of completion of the search | Examiner |
|---|---|---|
| Munich | 21 April 2026 | Ghidini, Mario |

EPO FORM 1503 03.82 (P04C01)

## ANNEX TO THE EUROPEAN SEARCH REPORT
## ON EUROPEAN PATENT APPLICATION NO.

EP 25 21 6346

This annex lists the patent family members relating to the patent documents cited in the above-mentioned European search report.
The members are as contained in the European Patent Office EDP file on
The European Patent Office is in no way liable for these particulars which are merely given for the purpose of information.

21-04-2026

| Patent document cited in search report | Publication date | Patent family member(s) | | Publication date |
|---|---|---|---|---|
| WO 2024030545 A1 | 08-02-2024 | NONE | | |
| US 2011131356 A1 | 02-06-2011 | NONE | | |
| EP 3944090 A1 | 26-01-2022 | EP | 3944090 A1 | 26-01-2022 |
| | | US | 2022018881 A1 | 20-01-2022 |

EPO FORM P0459

For more details about this annex : see Official Journal of the European Patent Office, No. 12/82